# EUROPÄISCHE PATENTANMELDUNG

(11) **EP 1 489 698 A2**
(43) Veröffentlichungstag der Anmeldung: **22.12.2004**
(21) Anmeldenummer: 04012942.1
(22) Anmeldetag: 01.06.2004
(51) Int. Cl.: H01R 12/38

(54) **Vorrichtung und Verfahren zum elektrischen Verbinden eines elektrischen Leiters mit einem elektronischen Bauelement**

(30) Priorität: 06.06.2003 DE 10325884
(71) Anmelder: Infineon Technologies AG, 81669 München (DE)
(72) Erfinder: Jung, Stefan, 81249 München (DE); Lauterbach, Christl, 85635 Höhenkirchen-Siegertsbrunn (DE)
(74) Vertreter: Müller-Boré & Partner Patentanwälte

(57) **Zusammenfassung**

Die Erfindung betrifft eine Kontaktiereinrichtung zum elektrischen Verbinden eines elektrischen Leiters, insbesondere eines draht- und/oder fadenartigen elektrischen Leiters, welcher in einem textilen Material angeordnet ist, mit einem elektronischen Bauelement, umfassend:
- ein Substratmaterial;
- zumindest einen Kontakt, welcher an dem Substratmaterial ausgebildet ist, zum elektrischen Verbinden des Leiters mit der Kontaktiereinrichtung;
wobei
- der Kontakt einen beweglichen Abschnitt und einen unbeweglichen Abschnitt umfaßt, und
- der bewegliche Abschnitt derart ausgebildet ist, daß er beim Vorgang des elektrischen Verbindens dem unbeweglichen Abschnitt flächenseitig im wesentlichen gegenüberliegend angeordnet werden kann.
Ferner betrifft die Erfindung ein elektronisches Bauelement und ein Verfahren zum elektrischen Verbinden eines elektrischen Leiters.

## Beschreibung

Die Erfindung betrifft eine Kontaktiereinrichtung zum elektrischen Verbinden eines elektrischen Leiters mit einem elektronischen Bauelement gemäß Anspruch 1, ein elektronisches Bauelement gemäß Anspruch 6 sowie ein Verfahren gemäß Anspruch 7.

Viele denkbare Applikationen für intelligente Textilien (z.B. smart clothes oder flächige Textilien) können durch die Integration von elektronischen Bauelementen und Modulen in den Textilien realisiert werden. Elektrische Verbindungen zwischen in der Kleidung verteilten elektronischen Modulen können z.B. mit in textilen Geweben eingewobenen leitfähigen Drähten realisiert werden.

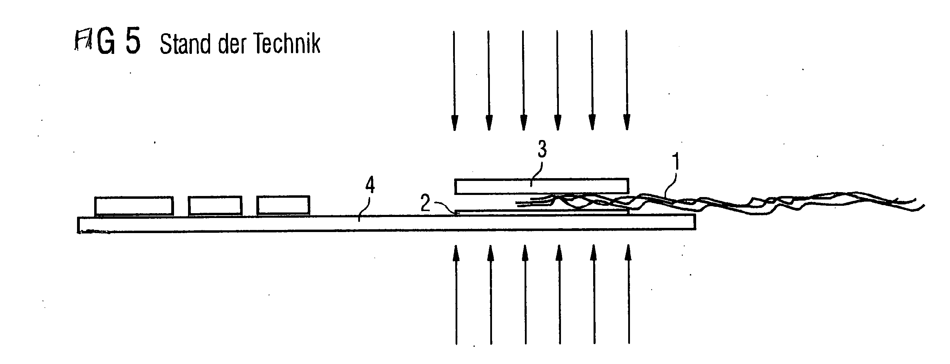

Nach dem Stand der Technik wird die Kontaktierung der leitfähigen Drähte mit den metallisierten Pads einer daran zu verbindenden Leiterplatte 4 durch thermisches Verbinden einer Sandwichstruktur realisiert. Der Kontaktiervorgang gemäß dem Stand der Technik ist in Fig. 5 dargestellt. Hierbei wird die abisolierte Faser 1 auf den Metallpad 2 gelegt und ein metallisches Gegenstück 3 wird an der dem Metallpad 2 entsprechenden Position auf der anderen Seite der abisolierten Faser 1 aufgelegt. Nachfolgend werden das Metallpad 2 und das metallische Gegenstück 3 durch thermisches Verbinden miteinander verbunden. Die bekannte Technik hat jedoch die Nachteile, daß die abisolierte Stelle 1 des leitfähigen Gewebes bezüglich der Metallpads 2 der Leiterplatte 4 justiert werden muß und daß für jede Verbindung ein metallisches Gegenstück 3 aufgelegt und ebenfalls justiert werden muß.

Es ist somit eine Aufgabe der vorliegenden Erfindung, eine Kontaktiereinrichtung, ein elektronisches Bauelement und ein Verfahren bereitzustellen, die ein einfacheres und verbessertes Verbinden von leitfähigen Fasern eines textilen Materials mit einem elektronischen Bauelement ermöglichen.

Diese Aufgabe wird gemäß der vorliegenden Erfindung gelöst durch eine Kontaktiereinrichtung mit den in Anspruch 1 angegebenen Merkmalen, ein elektronisches Bauelement mit den in Anspruch 6 angegebenen Merkmalen und ein Verfahren mit den in Anspruch 7 angegebenen Merkmalen. Bevorzugte Ausführungsformen sind Inhalt der abhängigen Ansprüche.

Gemäß der vorliegenden Erfindung wird eine Kontaktiereinrichtung bereitgestellt zum elektrischen Verbinden eines elektrischen Leiters, insbesondere eines draht- und/oder fadenartigen elektrischen Leiters, welcher in einem textilen Material angeordnet ist, mit einem elektronischen Bauelement, umfassend:
- ein Substratmaterial;
- zumindest einen Kontakt bzw. Kontaktpad bzw. metallischen Pad, welcher an bzw. auf dem Substratmaterial ausgebildet ist, zum elektrischen Verbinden des Leiters mit der Kontaktiereinrichtung;
wobei
- der Kontakt einen beweglichen bzw. klappbaren bzw. umklappbaren Abschnitt und einen unbeweglichen bzw. festgelegten bzw. festen Abschnitt umfaßt, und
- der bewegliche Abschnitt derart ausgebildet ist, daß er beim Vorgang des elektrischen Verbindens dem unbeweglichen Abschnitt flächenseitig im wesentlichen gegenüberliegend angeordnet werden kann.

Vorzugsweise ist der bewegliche Abschnitt derart ausgebildet, daß er beim Vorgang des elektrischen Verbindens auf den unbeweglichen Abschnitt geklappt werden kann bzw. wird.

Der bewegliche Abschnitt und der unbewegliche Abschnitt des Kontakts können als voreinander getrennte Einheiten oder als miteinander verbundene Einheiten ausgebildet sein.

Bei dem elektronischen Bauelement kann es sich beispielsweise um eine integrierte Schaltung (Chip) oder um eine auf einem Isolator aufgebrachte Leiterbahn, welche mit einem externen elektronischen Bauelement verbunden ist, handeln.

Vorzugsweise ist das textile Material ein Gewebe. Unter einem Gewebe wird hierbei ein textiles Flächengebilde aus zwei sich insbesondere rechtwinklig kreuzenden Fadensystemen verstanden, welche - wie üblich - als Kette und Schuß bezeichnet werden. Die Kette liegt in Längsrichtung des Webprozesses während die Schußrichtung quer zur Webrichtung verläuft.

Der Leiter umfaßt vorzugsweise zumindest einen Schuß- und/oder Kettfaden des Gewebes.

Vorzugsweise ist in dem von dem beweglichen Abschnitt und/oder dem unbeweglichen Abschnitt des Kontakts bedeckten Bereich des Substratmaterials eine Ausnehmung bzw. ein Durchbruch bzw. ein Loch in dem Substratmaterial vorgesehen. Somit sind der bewegliche Abschnitt und/oder der unbewegliche Abschnitt des Kontakts von dem Substratmaterial freigelegt.

Die Ausnehmung in dem Substratmaterial ist insbesondere vorteilhaft, wenn der bewegliche Abschnitt, der unbewegliche Abschnitt und der Leiter in einem Thermokompressionsschritt, wie z.B. Löten, miteinander elektrisch verbunden werden.

Hierbei kann durch der freigelegte Bereich des Kontakts direkt mit der Thermokompressionseinrichtung kontaktiert werden. Somit wird eine bessere Wärmeübertragung ermöglicht.

Bevorzugt sind der bewegliche Abschnitt und der unbewegliche Abschnitt miteinander verbunden. Hierbei ist vorzugsweise die Verbindungsstelle zwischen dem beweglichen Abschnitt und dem unbeweglichen Abschnitt der Punkt bzw. die Achse um welche der bewegliche Abschnitt bewegt wird, wenn er auf den unbeweglichen Abschnitt geklappt wird.

Vorzugsweise sind der bewegliche Abschnitt und der unbewegliche Abschnitt einstückig ausgebildet.

Somit kann die Festigkeit der Verbindung zwischen dem beweglichen und unbeweglichen Abschnitt des Kontakts und dem Leiter erhöht werden.

Vorzugsweise ist an bzw. auf dem Substratmaterial ferner zumindest eine Leiterbahn vorgesehen, welche mit dem zumindest einen Kontakt elektrisch verbunden ist.

Somit kann der Kontakt auf einfache und vorteilhafte Weise mit z.B. einem zu verbindenden Bauelement verbunden werden.

Gemäß der Erfindung wird ferner ein elektronisches Bauelement bereitsgestellt, welches eine Kontaktiereinrichtung gemäß der Erfindung oder einer bevorzugten Ausführungsform davon umfaßt.

Des weiteren wird ein Verfahren bereitgestellt zum elektrischen Verbinden eines elektrischen Leiters, insbesondere eines drahtund/oder fadenartigen elektrischen Leiters, welcher in einem textilen Material angeordnet ist, mit einer Kontaktiereinrichtung gemäß der Erfindung oder einer bevorzugten Ausführungsform davon, umfassend die Schritte:
- Bereitstellen eines textilen Materials, in welchem zumindest ein flexibler, draht- und/oder fadenartiger elektrischer Leiter angeordnet ist;
- Anordnen einer Kontaktiereinrichtung an einer Flächenseite des textilen Materials an der zu verbindenden Stelle des Leiters;
- Anordnen bzw. Umklappen des beweglichen Abschnitts der Kontaktiereinrichtung flächenseitig im wesentlichen gegenüberliegend zu dem unbeweglichen Abschnitt der Kontaktiereinrichtung;
- elektrisches Verbinden des Leiters mit der Kontaktierungseinrichtung.

Vorzugsweise umfaßt der Schritt des elektrischen Verbindens einen Schritt des zumindest teilweisen Erhitzens bzw. Erwärmens des Kontakts bzw. einen Thermokompressionsschritt.

Bevorzugt kann das Verfahren ferner einen Schritt des thermischen Verschweißens und/oder Verklebens der Kontaktiereinrichtung und des textilen Materials umfassen.

Weiter bevorzugt umfaßt das Verfahren ferner einen Schritt des zumindest bereichsweisen Auftragens bzw. Laminierens einer isolierenden Schicht bzw. Klebeschicht auf die Kontaktiereinrichtung und das textile Material, welche erfindungsgemäß miteinander verbunden sind.

Weitere Merkmale, Aufgaben und Vorteile der vorliegenden Erfindung werden offensichtlich auf der nachfolgenden Beschreibung von bevorzugten Ausführungsformen mit Bezug auf die Zeichnungen, in welchen zeigt:
- Fig. 1: eine Draufsicht auf eine Kontaktiereinrichtung während des Herstellungsprozesses einer erfindungsgemäßen Kontaktiereinrichtung;
- Fig. 2A: eine Kontaktiereinrichtung gemäß einer ersten bevorzugten Ausführungsform der vorliegenden Erfindung;
- Figs. 2B bis 2D: den Verbindungsvorgang zwischen der in Fig. 2A gezeigten Kontaktiereinrichtung und in einem textilen Material angeordneten elektrischen Leitern,
- Fig. 3A: eine Kontaktiereinrichtung gemäß einer zweiten bevorzugten Ausführungsform der vorliegenden Erfindung;
- Fig. 3B bis 3D: den Verbindungsvorgang der in Fig. 3A gezeigten Kontaktiereinrichtung;
- Fig. 4: eine Schnittansicht, welche einem Schnitt entsprechend Linie A-A von Fig. 2D entspricht, wobei die Kontaktiereinrichtung und das textile Gewebe zumindest bereichsweise ummantelt ist; und
- Fig. 5: eine Kontaktiereinrichtung gemäß dem Stand der Technik.

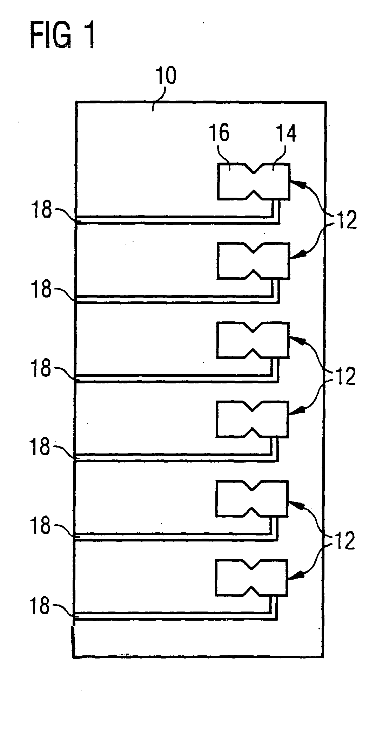

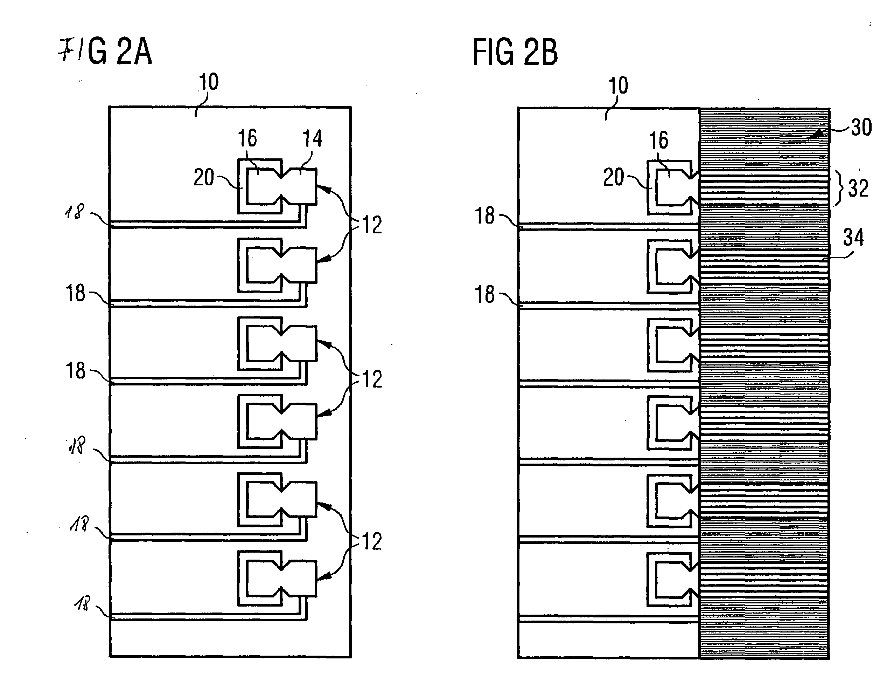

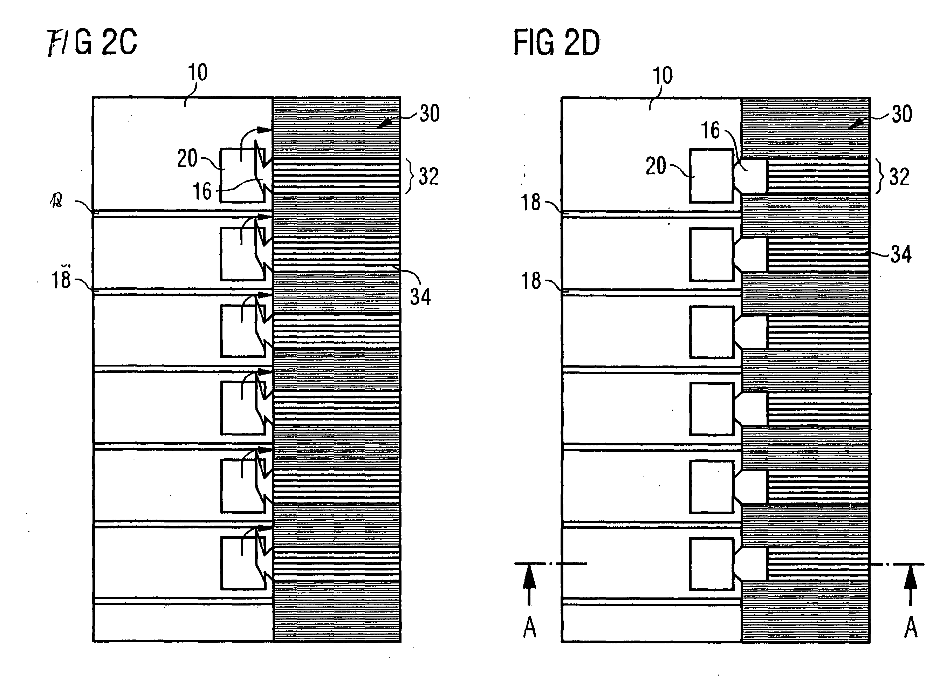

Nachfolgend wird zunächst der Herstellungsvorgang einer Kontaktiereinrichtung gemäß der ersten bevorzugten Ausführungsform der vorliegenden Erfindung mit Bezug auf Figs. 1 und 2A beschrieben.

Zunächst werden auf einem Substratmaterial 10 Kontakte 12 aufgebracht bzw. angeordnet bzw. ausgebildet. In der vorliegend dargestellten Ausführungsform sind sechs Kontakte 12 vorgesehen, wobei jedoch jede andere erforderliche Anzahl an Kontakten 12 vorgesehen werden kann. Die Kontakte 12 weisen zwei Abschnitte 14, 16 auf, wobei der Abschnitt 14 in der fertiggestellten Kontaktiereinrichtung einen unbeweglichen Abschnitt 14 ausbildet und der Abschnitt 16 einen beweglichen Abschnitt 16 ausbildet. In der dargestellten Ausführungsform sind die Abschnitte 14, 16 einstückig miteinander verbunden ausgebildet. Alternativ ist jedoch denkbar, daß die Abschnitte 14, 16 räumlich voneinander getrennt sind, d.h. nicht miteinander verbunden sind.

Des weiteren werden auf dem Substratmaterial Leitbahnen 18 ausgebildet, welche jeweils mit einem Kontakt 12 elektrisch verbunden sind und vorzugsweise dazu dienen, die Kontaktiereinrichtung mit einem (nicht gezeigten) elektronischen Bauelement zu verbinden.

In einem nächsten Verfahrensschritt, wie in Fig. 2A gezeigt, wird das Substratmaterial unterhalb des beweglichen Abschnitts 16 durch z.B. Lasern, Ätzen, etc., entfernt. Dadurch entsteht eine Ausnehmung bzw. ein Durchbruch bzw. ein Loch 20 in dem Substratmaterial 10. Gemäß der ersten bevorzugten Ausführungsform wird hierbei der bewegliche Abschnitt 16 im wesentlichen komplett von dem Substratmaterial 10 befreit bzw. freigelegt und kann somit bewegt werden.

Des weiteren kann in einem später beschriebenen Thermokompressionsschritt dem freigelegten beweglichen Abschnitt 16 auf vorteilhafte Weise Wärme bzw. Hitze zugeführt werden.

Nachfolgend wird der Ablauf des Verbindens der Kontaktiereinrichtung mit in einem textilen Material angeordneten Leitern mit Bezug auf Figs. 2B bis 2D im Detail beschrieben.

Vorzugsweise ist das textile Material 30 ein Gewebe. Unter einem Gewebe wird hierbei ein textiles Flächengebildet aus zwei sich insbesondere rechtwinklig kreuzenden Fadensystemen verstanden, welche - wie üblich - als Kette und Schuß bezeichnet werden. Die Kette liegt in Längsrichtung des Webprozesses während die Schußrichtung quer zur Webrichtung verläuft.

In dem textilen Material 30 sind in der dargestellten Ausführungsform sechs Leiter 32 eingewebt. In der dargestellten Ausführungsform besteht ein Leiter 32 jeweils aus mehreren im wesentlichen parallel zueinander verlaufenden elektrisch leitenden Drähten bzw. Garnen bzw. Fasern 34, welche vorzugsweise von einer elektrisch isolierenden Ummantelung bzw. Isolierung (nicht dargestellt) umgeben sind.

Zunächst wird an der zu kontaktierenden Stelle des Leiters 32 die Isolierung des Drahts 34 entfernt, so daß der Innenleiter freiliegt.

Dann wird das so vorbereitete textile Material 30 mit den Leitern 32 derart an der Kontaktiereinrichtung angeordnet, daß die unbeweglichen Abschnitte 14 des Kontakte 12 im wesentlichen von den Leitern 32 bedeckt werden.

Nachfolgend wird der bewegliche Abschnitt 16 des Kontakts 12 umgeklappt und bedeckt nun den Leiter 32. Das textile Material 30 und die darin eingewebten Leiter 32 werden im wesentlichen zwischen den einander nun im wesentlichen gegenüberliegenden Abschnitts 14, 16 des Kontakts 12 gehalten und positioniert.

Durch das Umklappen des beweglichen Abschnitts 16 kann ferner eine gute Positionierung des textilen Materials 30 bezüglich der Kontaktiereinrichtung erreicht werden.

In einem nachfolgenden Thermokompressionsschritt, bei welchem die Wärme bzw. Hitze auf den freigelegten beweglichen Abschnitt 16 aufgebracht wird kann ein guter Verbund zwischen dem Kontakt 12 und dem Leiter 32 ausgebildet werden. Vorzugsweise kann der Kontakt 12 an der dem textilen Material 30 zugewendeten Seite mit einem Lotmittel, vorzugsweise Lötzinn versehen sein, welches während des Thermokompressionsschritts in das textile Material eindringt und somit eine stabile elektrische und mechanische Verbindung ausbildet. Alternativ kann an Stelle des Lotmittles ein Leitkleber verwendet werden.

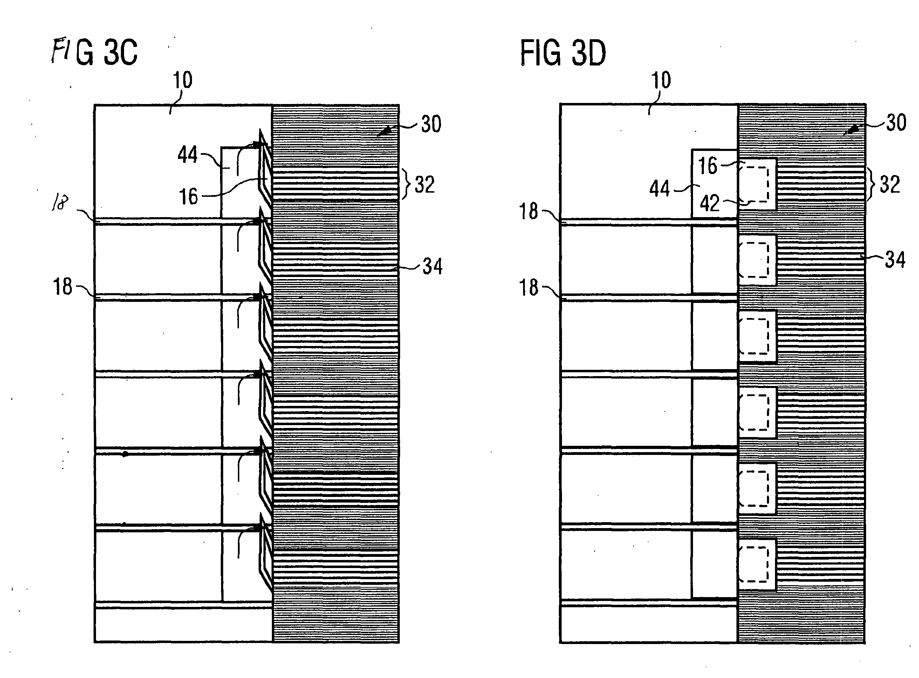

Nachfolgend wird eine Kontaktiereinrichtung gemäß der zweiten bevorzugten Ausführungsform der vorliegenden Erfindung mit Bezug auf Figs. 3A bis 3D beschrieben.

Zunächst wird der Herstellungsprozess einer Kontaktiereinrichtung gemäß der zweiten bevorzugten Ausführungsform mit Bezug auf Fig. 1 und 3A beschrieben.

Ähnlich wie bezüglich der ersten Ausführungsform beschrieben, wird eine wie in Fig. 1 gezeigte Anordnung ausgebildet. Um eine Kontaktiereinrichtung gemäß der zweiten Ausführungsform zu erhalten, wird das Substratmaterial 10 jedoch unterhalb des unbeweglichen Abschnitts 14 des Kontakts 12 entfernt. Dies ist in Fig. 3A durch das gestrichelte Kästchen mit Bezugszeichen 42 angedeutet. Ferner wird im wesentlichen umfänglich um den beweglichen Abschnitt 16 ein Schnitt gemacht, so daß der bewegliche Abschnitt 16 aus der Substratmaterialebene umgeklappt bzw. herausgeklappt werden kann. Dies ist in Fig. 3A mit dem Bezugszeichen 40 angedeutet.

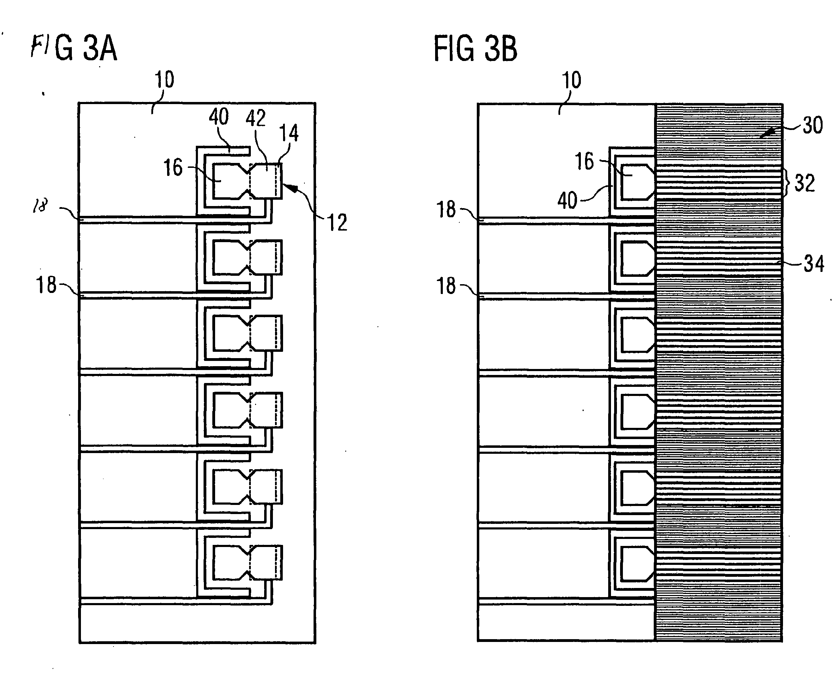

Nachfolgend wird der Verbindungsvorgang mit Bezug auf Figs. 3B bis 3D im Detail beschrieben.

Ähnlich wie gemäß der ersten Ausführungsform wird ein textiles Material 30, in welchem ein Leiter 32 eingewebt ist und bei welchem die Enden der Leiter 32 abisoliert wurden an der Kontaktiereinrichtung angeordnet. Der bewegliche Abschnitt 16 wird auf den unbeweglichen Abschnitt 14 und das textile Material 30 umgeklappt (Fig. 3C). In einem Thermokompressionsschritt werden dann die Abschnitte 14, 16 des Kontakts 12 mit dem textilen Material 30 elektrisch verbunden. Hierbei wird in dieser Ausführungsform die Hitze bzw. Wärme durch die Ausnehmung 42 in dem Substratmaterial 10 unterhalb des unbeweglichen Abschnitts 14 des Kontakts 12 zugeführt.

Das elektrische Verbinden kann ähnlich geführt werden wie bezüglich der ersten Ausführungsform beschrieben.

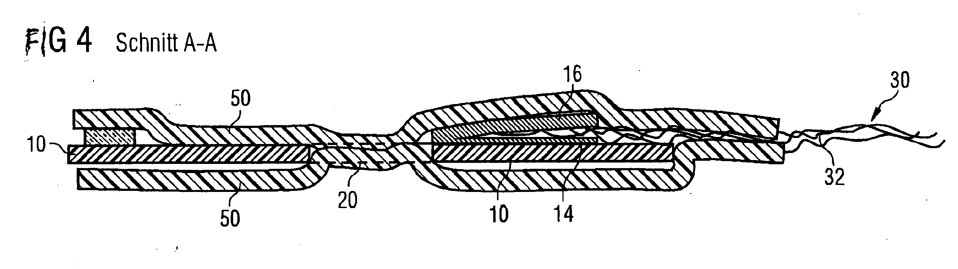

In Fig. 4 ist eine Kontaktiereinrichtung gemäß der ersten Ausführungsform in einem verbundenen Zustand gezeigt. Hierbei wurde jedoch zusätzlich die Kontaktiereinrichtung, das textile Material 30 und der Leiter 32 zumindest bereichsweise beidseitig mit einem Isolator 50 beschichtet. Durch die zusätzliche Beschichtung können die Kontakte zum einem gegen das Eindringen von Schmutz und Feuchtigkeit geschützt werden, zum anderen kann ein besserer mechanischer Halt zwischen dem textilen Material 30 und der Kontaktiereinrichtung ausgebildet werden. Der mechanische Halt wird zusätzlich dadurch verbessert, daß der Isolator 50, welcher an der Oberseite und Unterseite vorhanden ist durch die Ausnehmung 20 hindurchtritt und sich hier verbindet.

Bei Verwendung einer Kontaktiereinrichtung gemäß der zweiten bevorzugten Ausführungsform kann ebenfalls ein Isolator 50 vorgesehen werden.

Bei den vorstehend beschriebenen Ausführungsformen wurde die Kontaktiereinrichtung jeweils an einem Rand- bzw. Seitenbereich des textilen Materials 30 angeordnet. Es ist jedoch ebenfalls denkbar, die Kontaktiereinrichtung in einem Mittelbereich des textilen Materials 30 anzuordnen. Hierbei wird die Isolierung der Leiter an den zu kontaktierenden Stellen entfernt und das nicht-leitende textile Material durchtrennt, so daß der bewegliche Abschnitt 16 der Kontakte 12 durch das textile Material hindurchtreten kann. Vorzugsweise sind ferner die Kontakte 12 sowie alle Ausnehmungen 20, 42, 44 um 90° gedreht. Somit können die abisolierten Leiter 32 seitlich mit der Kontaktiereinrichtung verbunden werden und nicht frontal, wie in den dargestellten Ausführungsformen.

### Bezugszeichenliste

- 1: Faser
- 2: Pad
- 3: Gegenstück
- 4: Leiterplatte
- 10: Substratmaterial
- 12: Kontakt
- 14: unbeweglicher Abschnitt
- 16: beweglicher Abschnitt
- 18: Leiterbahn
- 20: Ausnehmung
- 30: textiles Material
- 32: Leiter
- 34: Draht
- 40: Schnitt
- 42: Ausnehmung
- 44: Ausnehmung
- 50: Isolator

## Patentansprüche

1. Kontaktiereinrichtung zum elektrischen Verbinden eines elektrischen Leiters (32), insbesondere eines draht- und/oder fadenartigen elektrischen Leiters (32), welcher in einem textilen Material (30) angeordnet ist, mit einem elektronischen Bauelement, umfassend:
- ein Substratmaterial (10);
- zumindest einen Kontakt (12), welcher an dem Substratmaterial (10) ausgebildet ist, zum elektrischen Verbinden des Leiters (32) mit der Kontaktiereinrichtung; wobei
- der Kontakt (12) einen beweglichen Abschnitt (16) und einen unbeweglichen Abschnitt (14) umfaßt, und
- der bewegliche Abschnitt (16) derart ausgebildet ist, daß er beim Vorgang des elektrischen Verbindens dem unbeweglichen Abschnitt (14) flächenseitig im wesentlichen gegenüberliegend angeordnet werden kann.

2. Kontaktiereinrichtung gemäß Anspruch 1, wobei in dem von dem beweglichen Abschnitt (16) und/oder dem unbeweglichen Abschnitt (14) des Kontakts (12) bedeckten Bereich des Substratmaterials (10) eine Ausnehmung (20; 42) in dem Substratmaterial (10) vorgesehen ist.

3. Kontaktiereinrichtung gemäß einem der vorangehenden Ansprüche, wobei der bewegliche Abschnitt (16) und der unbewegliche Abschnitt (14) miteinander verbunden sind.

4. Kontaktiereinrichtung gemäß Anspruch 3, wobei der bewegliche Abschnitt (16) und der unbewegliche Abschnitt (14) einstückig ausgebildet sind.

5. Kontaktiereinrichtung gemäß einem der vorangehenden Ansprüche, wobei an dem Substratmaterial (10) ferner zumindest eine Leiterbahn (18) vorgesehen ist, welche mit dem zumindest einen Kontakt (12) elektrisch verbunden ist.

6. Elektronisches Bauelement, umfassend eine Kontaktiereinrichtung gemäß einem der vorangehenden Ansprüche.

7. Verfahren zum elektrischen Verbinden eines elektrischen Leiters (32), insbesondere eines draht- und/oder fadenartigen elektrischen Leiters (32), welcher in einem textilen Material (30) angeordnet ist, mit einer Kontaktiereinrichtung gemäß einem der Ansprüche 1 bis 5, umfassend die Schritte:
- Bereitstellen eines textilen Materials (30), in welchem zumindest ein flexibler, draht- und/oder fadenartiger elektrischer Leiter (32) angeordnet ist;
- Anordnen einer Kontaktiereinrichtung an einer Flächenseite des textilen Materials (30) an der zu verbindenden Stelle des Leiters (32);
- Anordnen des beweglichen Abschnitts (16) der Kontaktiereinrichtung flächenseitig im wesentlichen gegenüberliegend zu dem unbeweglichen Abschnitt (14) der Kontaktiereinrichtung;
- elektrisches Verbinden des Leiters (32) mit der Kontaktierungseinrichtung.

8. Verfahren gemäß Anspruch 7, wobei der Schritt des elektrischen Verbindens einen Schritt des zumindest teilweisen Erhitzens des Kontakts (12) umfaßt.

9. Verfahren gemäß einem der Ansprüche 7 oder 8, welches ferner einen Schritt des thermischen Verschweißens und/oder Verklebens der Kontaktiereinrichtung und des textilen Materials (30) umfaßt.

10. Verfahren gemäß einem der Ansprüche 7 bis 9, welches ferner einen Schritt des zumindest bereichsweisen Auftragens einer isolierenden Schicht auf die Kontaktiereinrichtung und das textile Material (30), welche miteinander verbundenen sind, umfaßt.
